(19) Europäisches Patentamt
European Patent Office
Office européen des brevets

(11) **EP 4 674 628 A1**

(12) **EUROPEAN PATENT APPLICATION**

(43) Date of publication:
**07.01.2026 Bulletin 2026/02**

(21) Application number: **25187249.5**

(22) Date of filing: **03.07.2025**

(51) International Patent Classification (IPC):
**B41J 2/175** (2006.01)

(52) Cooperative Patent Classification (CPC):
**B41J 2/17503; B41J 2/1753; B41J 2/17546;
B41J 2/17559**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.07.2024 JP 2024108479**

(71) Applicant: **CANON KABUSHIKI KAISHA
Tokyo 146-8501 (JP)**

(72) Inventor: **SAITO, Takaaki
Tokyo, 146-8501 (JP)**

(74) Representative: **TBK
Bavariaring 4-6
80336 München (DE)**

(54) **RECYCLING METHOD OF CARTRIDGE AND CARTRIDGE**

(57) An object of the present disclosure is to provide a recycling method of a cartridge (120) that has the potential to contribute to the achievement of a sustainable society, such as a decarbonized society/circular society. The recycling method of the cartridge (120) includes: performing electrical evaluation to evaluate an electrical characteristic of a printing element substrate (123) by supplying electric power to the printing element substrate (123) from a wiring substrate; performing outer appearance evaluation to evaluate an outer appearance of the cartridge (120) based on the number of ejection ports (301) having a problem out of multiple ejection ports (301); and determining whether to recycle the cartridge (120) based on a result of the electrical evaluation and a result of the outer appearance evaluation.

FIG.6

EP 4 674 628 A1

**Description**

TECHNICAL FIELD

The present disclosure relates to a recycling method of a cartridge and the cartridge.

BACKGROUND

Japanese Patent Laid-Open No. 2002-264435 discloses a recycling determination method to determine whether to recycle in a case of recycling a cartridge for a printer based on whether, the number of days elapsed from the date on which the cartridge is newly mounted on the printer or the like is within a specified value. According to the method in Japanese Patent Laid-Open No. 2002-264435, in a case where the number of days elapsed, the number of sheets printed, or the like from the date on which the cartridge is newly mounted on the printer is within the specified value, it is determined that the cartridge is appropriate for recycling.

In addition, in the method in Japanese Patent Laid-Open No. 2002-264435, after the above-described cartridge is automatically determined to be inappropriate for recycling, whether the cartridge is appropriate for recycling is determined again by visual check.

According to the method in Japanese Patent Laid-Open No. 2002-264435, even in a case where the cartridge is determined to be inappropriate for recycling, the cartridge may be salvaged by the subsequent visual check.

In the visual check in Japanese Patent Laid-Open No. 2002-264435, it has been possible to check whether the cartridge has a problem in an outer appearance. However, it has been difficult to determine whether the cartridge has a problem inside. Thus, the method disclosed in Japanese Patent Laid-Open No. 2002-264435 had room for improvement in accuracy of the determination.

SUMMARY

An object of the present disclosure is to provide a method of accurately determining whether a cartridge is recyclable.

A recycling method a cartridge according to the present disclosure includes: a tank configured to contain ink, a printing element substrate including a plurality of printing elements configured to generate energy to eject the ink according to an electric signal and a plurality of ejection ports formed in positions corresponding to the plurality of printing elements, and a wiring substrate in which the electric signal supplied to the printing element substrate is inputted, performing electrical evaluation to evaluate an electrical characteristic of the printing element substrate by supplying electric power to the printing element substrate from the wiring substrate; performing outer appearance evaluation to evaluate an outer appearance of the cartridge based on the number of the ejection ports having a problem out of the plurality of ejection ports; and determining whether to recycle the cartridge based on a result of the electrical evaluation and a result of the outer appearance evaluation.

Features of the present disclosure will become apparent from the following description of embodiments with reference to the attached drawings. The following description of embodiments are described by way of example.

BRIEF DESCRIPTION OF THE DRAWINGS

Fig. 1 is a block diagram of a liquid ejection apparatus applicable to an embodiment;

Fig. 2 is a perspective view of a head cartridge applicable to an embodiment;

Fig. 3 is a bottom view of the head cartridge applicable to an embodiment;

Fig. 4 is a cross-sectional view of a printing element substrate applicable to an embodiment;

Fig. 5 is a flowchart illustrating a reference example of a recycling method;

Fig. 6 is a diagram illustrating a subroutine in S502;

Fig. 7 is a flowchart illustrating the recycling method applicable to an embodiment;

Fig. 8 is a diagram illustrating a subroutine in S703;

Fig. 9 is a diagram illustrating a subroutine in S706;

Fig. 10 is a diagram illustrating a subroutine in S707;

Fig. 11 is a diagram illustrating a subroutine in S708;

Fig. 12 is a diagram illustrating a subroutine in S709;

Fig. 13 is a flowchart illustrating the recycling method applicable to an embodiment;

Fig. 14 is a diagram illustrating a subroutine in S1301; and

Fig. 15 is a diagram illustrating a subroutine in S1302.

DESCRIPTION OF THE EMBODIMENTS

The technologies described in this specification have the potential to contribute to the achievement of a sustainable society, such as a decarbonized society/circular society. In the present embodiment, a recycling method of a liquid cartridge is described as the technology that has the potential to contribute to the achievement of a substantial society.

[First Embodiment]

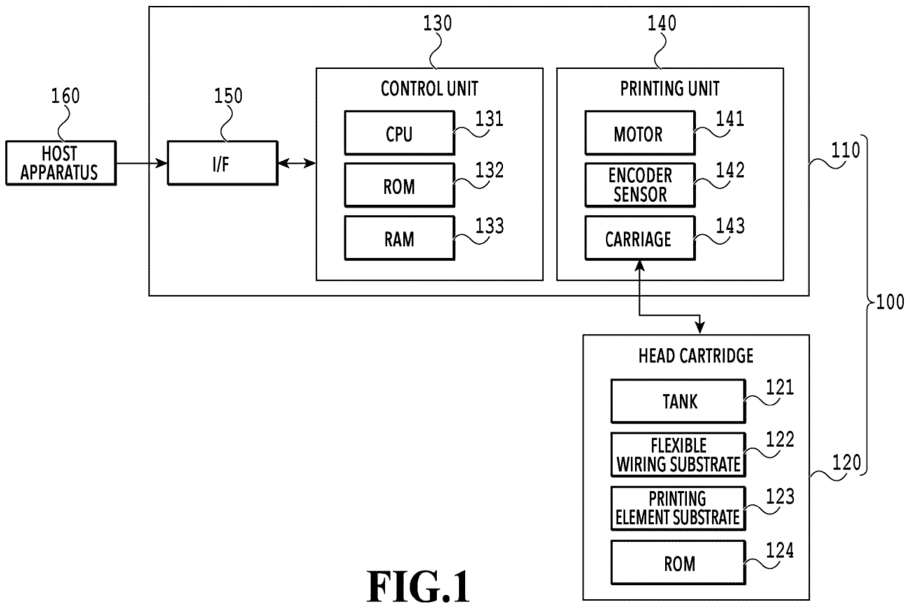

Fig. 1 is a block diagram illustrating a hardware configuration of a liquid ejection apparatus 100 applicable to the present embodiment.
As illustrated in Fig. 1, the liquid ejection apparatus 100 includes a main body 110 and a head cartridge 120. Note that, although the number of the head cartridge 120 is one in Fig. 1, multiple head cartridges 120 may be attached. For example, it is possible to perform full-color printing by mounting one head cartridge ejecting black ink and one head cartridge ejecting color ink (yellow ink, magenta ink, and cyan ink).
As a matter of course, multiple (for example, two) head cartridges ejecting the black ink may be attached. With this configuration, it is possible to contain a great amount of the black ink that is used frequently, and it is convenient in a case of performing monochrome printing.
The main body 110 includes a control unit 130 that controls operations of the overall liquid ejection apparatus 100 comprehensively and a printing unit 140 that performs printing on a printing medium (for example, a not-illustrated sheet) based on the received data. The main body 110 includes an I/F (interface) 150 that is configured to be able to receive the data to be used for printing from an external apparatus (for example, a host apparatus 160)
The control unit 130 is connected to the host apparatus 160 via the I/F 150. The control unit 130 includes a CPU 131, a ROM 132 that stores a control program that should be executed by the CPU 131, and a RAM 133 that is used as a buffer and the like of data.
The CPU 131 executes a processing operation such as computation, selection, determination, and control and a printing operation. The ROM 132 stores a program to execute processing of software. The RAM 133 is configured to be able to develop image data instructed to be printed so as to be converted into data necessary for printing.
The control unit 130 may include a constituent other than the above (for example, an input and output port to transmit and receive data to and from the printing unit 140 and the I/F 150). The printing unit 140 includes a carriage motor 141 to scan a carriage 143 in a scanning direction and the carriage 143 configured to be able to attach and detach the head cartridge 120. The printing unit 140 may include a constituent other than the above (for example, an input and output port to transmit and receive data to and from the control unit 130 and the carriage 143).
As described above, the head cartridge 120 is configured to be attachable and detachable to and from and be replaceable from the carriage 143. The head cartridge 120 includes a tank 121 that can be filled with and contain a liquid (for example, the ink) and a flexible wiring substrate 122 that can be electrically connected to a contact portion (not illustrated) of the carriage 143.
The head cartridge 120 includes a printing element substrate 123 that performs printing by ejecting the liquid on the printing medium and a fuse ROM 124 that stores a remaining amount of the liquid in the tank 121. In addition to the remaining amount of the liquid, in the present embodiment, the fuse ROM 124 stores a rank and the like indicating how good the state of the head cartridge 120 is (for example, a damage level of the outer appearance, a change in the electrical characteristic, and the like). Note that, although the fuse ROM 124 is used in the present embodiment, an EEPROM may be used instead thereof.

The head cartridge 120 is configured to be able to transmit and receive the information stored in the fuse ROM 124 to and from the control unit 130 via the flexible wiring substrate 122 while being mounted on the carriage 143.

Additionally, various pieces of information are stored in a storage region of the fuse ROM 124 in addition to the above-described information. The fuse ROM 124 is configured to be able to store a point of time at which the head cartridge 120 is newly mounted on the carriage 143 of the liquid ejection apparatus 100 that ejects the liquid (for example, the ink). For example, the date on which the head cartridge 120 is newly mounted on the carriage 143 and the number of days elapsed from the date are stored appropriately in the storage region of the fuse ROM 124 by the control unit.

Additionally, the fuse ROM 124 is configured to be able to store the number of times of printing in which the liquid (for example, the ink) is ejected onto the printing medium. For example, the number of sheets printed and the like that are counted up continuously since the head cartridge 120 is newly mounted on the carriage 143 are stored appropriately in the storage region of the fuse ROM 124 by the control unit.

Note that, in addition to the above-described configuration, the main body 110 includes a feeding unit (not illustrated) that feeds the printing medium, a conveyance unit (not illustrated) that conveys the fed printing medium, a discharge unit (not illustrated) that discharges the printing medium on which printing is completed, and the like. In addition to the above, the main body 110 includes a discharge tray (not illustrated) on which the discharged printing media are stacked and saved.

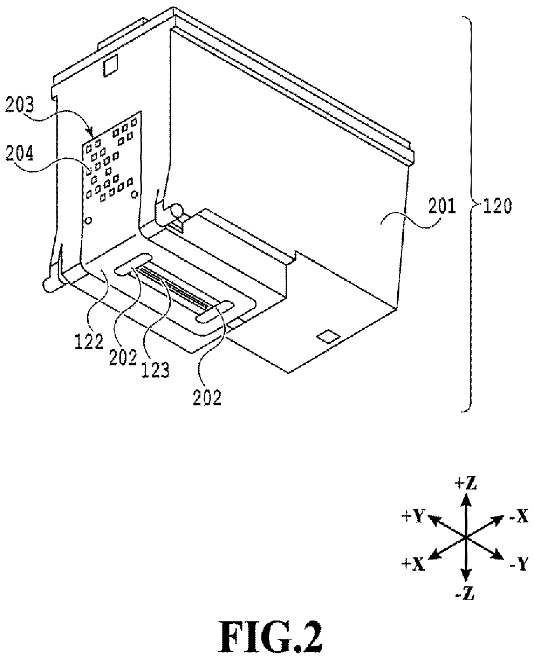

Fig. 2 is a perspective view of an example of the head cartridge 120 applicable to the present embodiment that is viewed from below on a back surface side.

As illustrated in Fig. 2, the head cartridge 120 includes a mold member 201 formed by molding resin. The mold member 201 functions as a main body portion of the head cartridge 120.

A bottom surface of the head cartridge 120 is provided with the printing element substrate 123 on which multiple printing elements to eject the liquid (for example, the black ink) are arranged along a conveyance direction (a -Y direction) of the printing medium (not illustrated). The printing element substrate 123 is surrounded by the flexible wiring substrate 122 in a sheet shape having flexibility, and electric power required to eject the liquid and an ejection signal are supplied from the flexible wiring substrate 122.

Additionally, an electrical connection portion between the flexible wiring substrate 122 and the printing element substrate 123 is sealed by a sealing member 202. Thus, the connection portion between the flexible wiring substrate 122 and the printing element substrate 123 is protected, and safety is ensured.

The flexible wiring substrate 122 extends across a back surface (a surface facing in a +Y direction) from the bottom surface (a surface facing in a -Z direction) of the head cartridge 120. In the flexible wiring substrate 122, a surface (a surface facing in the +Y direction) facing in the same direction as that of the back surface of the mold member 201 is provided with a contact portion 203 that can be electrically connected to the contact portion (not illustrated) of the carriage 143(see Fig. 1).

The contact portion 203 includes multiple terminals 204. While the contact portion 203 of the head cartridge 120 is connected to the contact portion of the carriage, the printing element substrate 123 is supplied with the electric power transmitted from the control unit 130 (see Fig. 1) and the ejection signal to eject the liquid.

The head cartridge 120 is configured to be able to perform printing on the printing medium supported by the above-described feeding unit (not illustrated) and conveyance unit (not illustrated). While the carriage scans along the scanning direction (an X direction), the head cartridge 120 ejects the liquid according to the ejection signal and forms an image of one band on the printing medium.

Once the scanning of one band as described above ends, the conveyance unit conveys the printing medium in the conveyance direction (the -Y direction) by an amount corresponding to one band width of the printing scanning. Then, the image is gradually formed on the printing medium by repeating the above-described scanning and conveyance operation alternately. Once all the scanning ends, the printing medium is discharged onto the discharge tray (not illustrated) by the discharge unit (for example, a not-illustrated discharge roller).

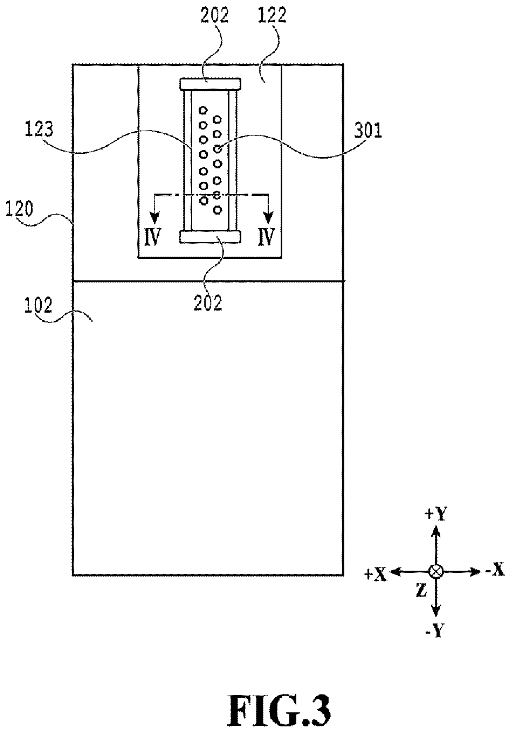

Fig. 3 is a schematic bottom view of the head cartridge 120 applicable to the present embodiment.

As illustrated in Fig. 3, multiple ejection ports 301 to eject the liquid are formed in the printing element substrate 123. One ejection port array is formed by arranging the multiple ejection ports 301 along the conveyance direction (a Y direction).

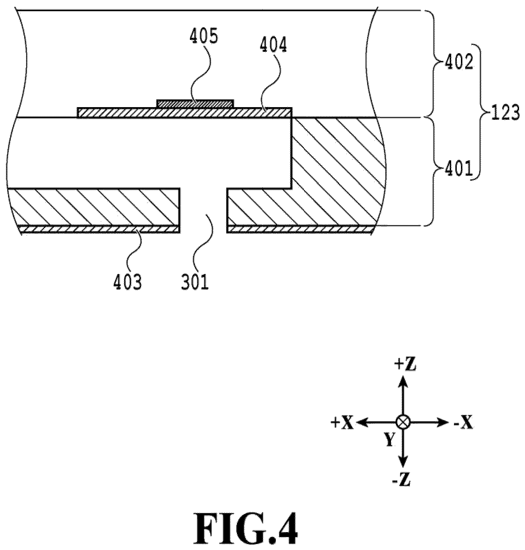

Fig. 4 is a schematic cross-sectional view of the printing element substrate 123 applicable to the present embodiment.

As illustrated in Fig. 4, the printing element substrate 123 includes an ejection port formation member 401 in which the ejection port 301 is formed and an element substrate 402 laminated on the ejection port formation member 401.

A water-repellent layer 403 is formed on a bottom surface (a surface facing in the -Z direction) of the ejection port formation member 401. Thus, the liquid ejected from the ejection port 301 is drained well, and it is possible to improve the image quality more than a case where the water-repellent layer 403 is not formed. Note that, in the present embodiment, the water-repellent layer 403 is not a necessary configuration.

A lower surface of the element substrate 402 is fixed on an upper surface (a surface facing in the +Z direction) of the ejection port formation member 401. A cavitation resistance layer 404 having impact resistance is formed inside the element substrate 402.

A heater 405 is provided in a position corresponding to the ejection port 301 inside the element substrate 402. The heater 405 is heated by supplying the heater 405 with the electric power via the flexible wiring substrate 122 (see Fig. 1 and the like). With the heater 405 being heated, it is possible to generate an air bubble in the liquid filling the inside of the ejection port formation member 401 and eject the liquid from the ejection port 301.

An impact is applied to the heater 405 by generating the air bubble. The impact is mitigated by the cavitation resistance layer 404. Thus, it is possible to extend the lifespan of the heater 405 more than a case without the cavitation resistance layer 404.

Note that, although the multiple ejection ports 301 are formed in the present embodiment, equal to or more than the actual number of use of the ejection ports 301 and the heaters 405 may be formed in the printing element substrate 123 for stable image formation. In this case, the ejection port 301 in an end portion is not used, and the heater 405 provided in the position corresponding to the ejection port 301 in the end portion is a dummy element (a dummy heater) to which no electric power is supplied.

On the other hand, the heater 405 other than the dummy heater functions as an actual element (an actual heater) to which the electric power is supplied. It is possible to control which of the multiple heaters 405 to function as the actual heater and which thereof to be treated as the dummy heater during the printing operation by using the CPU 131 (see Fig. 1).

Note that, it is also possible prevent the ejection of the liquid from the ejection port 301 positioned in the end portion of the printing element substrate 123 by not connecting wiring to the heater 405 (that is, the dummy heater) positioned in the end portion of the printing element substrate 123.

<Recycling of Head Cartridge>

Incidentally, there is a case where a used head cartridge is collected and reproduced as a new head cartridge. That is, there is a case where the head cartridge is recycled.

<Reference Example>

In order to make the understanding of the recycling method in the present embodiment easy, first, a reference example of the recycling method of the head cartridge is described below. Note that, a sign "S" in description of each processing means a step in the flowchart (hereinafter, the same applies to the present specification).

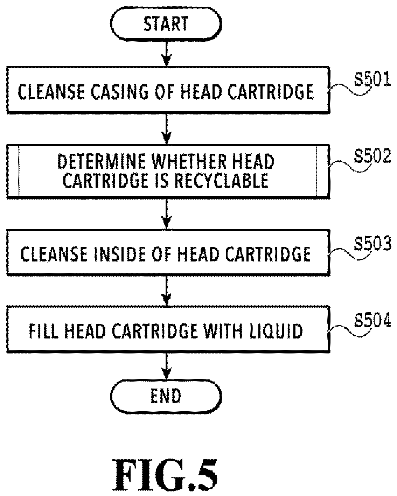

Fig. 5 is a flowchart illustrating a procedure of a general recycling method of the head cartridge as the reference example.

In S501, a casing of the head cartridge is cleansed.

In S502, whether it is possible to recycle the head cartridge is determined.

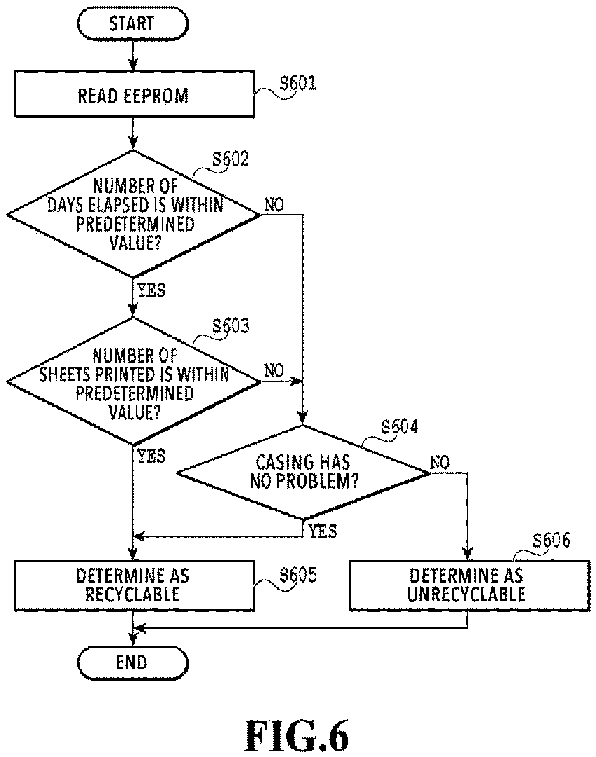

Fig. 6 is a diagram illustrating the subroutine in S502. The present subroutine includes a step of automatic determination according to a predetermined program by a CPU of a predetermined inspection apparatus and a step that is performed through human intervention.

In S601, the CPU reads information in a memory attached to the head cartridge. As the information, the number of days elapsed, the number of sheets printed, and the like from the date on which the head cartridge is mounted on the apparatus are included.

In S602, the CPU determines whether the number of days elapsed from the date on which the head cartridge is newly mounted on the carriage is within a predetermined value. If the number of days elapsed from the date on which the head cartridge is newly mounted on the carriage is within the predetermined value, processing in S603 is performed. On the other hand, if the number of days elapsed from the date on which the head cartridge is newly mounted on the carriage exceeds the predetermined value, processing in S604 is performed.

In S603, the CPU determines whether the number of the printing media on which printing is performed by using the head cartridge (the number of sheets printed) is within a predetermined value. If the number of sheets printed is within the predetermined value, processing in S605 is performed. On the other hand, if the number of sheets printed exceeds the predetermined value, processing in S606 is performed.

In S604, whether the casing of the head cartridge has a problem is determined. For example, whether the head cartridge is damaged to the extent that it is difficult to be reused is determined. The determination step may be performed through human intervention. If the casing of the head cartridge has no problem (YES in S604), the processing in S605 is performed. On the other hand, if the casing of the head cartridge has a problem (NO in S604), the processing in S606 is performed.

In S605, it is determined that the head cartridge is recyclable.

In S606, it is determined that the head cartridge is unrecyclable. In S606, the cartridge that is determined to be unrecyclable is discarded directly. With this, the present subroutine ends.

Referring back to Fig. 5, and the reference example of the recycling method of the head cartridge is described below. In S605, after S502 ends, processing in S503 is performed on the cartridge that is determined to be recyclable.

In S503, the inside of the head cartridge is cleansed.

In S504, the head cartridge is filled with the liquid (for example, the ink).

As described above, according to the method of the reference example, salvage of the head cartridge that is temporarily determined to be inappropriate for recycling is implemented by the visual check performed after the determination. However, with this method, even in a case of passing the visual check in S604, the inside of the head cartridge may have a problem. That is, even in a case where there is a problem inside, the head cartridge having no problem outside is determined as a recycling target. Thus, the recycling method of the reference example has room for improvement.

The above is description of the reference example of the recycling method of the head cartridge. An example of the recycling method of the head cartridge applicable to the present embodiment is described.

<Example of Recycling method>

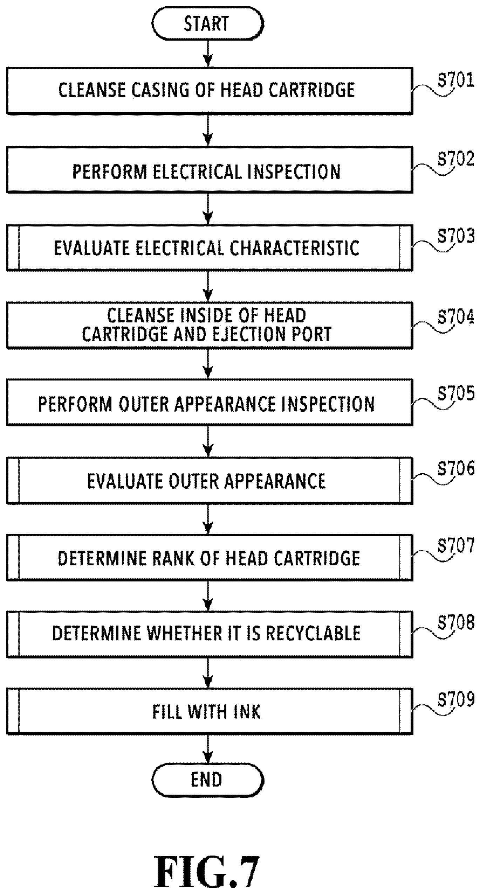

Fig. 7 is a flowchart illustrating the recycling method of the head cartridge applicable to the present embodiment. Under the assumption that the recycling method of the present embodiment is performed, a used head cartridge is collected. Note that, before the present flowchart starts, the visual check may be performed, and the head cartridge that is clearly inappropriate for recycling may be exempted from the recycling target. For example, the head cartridge having a cracked main body portion that is difficult to be filled with the ink newly may not be recycled.

In S701, the casing of the head cartridge is cleansed.

In S702, electrical inspection of the head cartridge is performed. In S702, a tester is applied to the contact portion 203 (see Fig. 2) to inspect whether a current is applied to the printing element substrate 123. If no current is applied to the printing element substrate 123, the head cartridge may be discarded. For example, a predetermined standard may be provided, and a head cartridge that does not satisfy the standard and is clearly corrupted electrically may be discarded. On the other hand, if the current is applied, the resistance values of the multiple actual heaters used in the actual ejection and the resistance value of the dummy heater that is not used in the actual ejection are measured and saved in a predetermined memory. In a case where the actual heater for the resistance value measurement is identified in advance, only the resistance value of the heater may be measured.

In S703, the electrical characteristic of the head cartridge is evaluated.

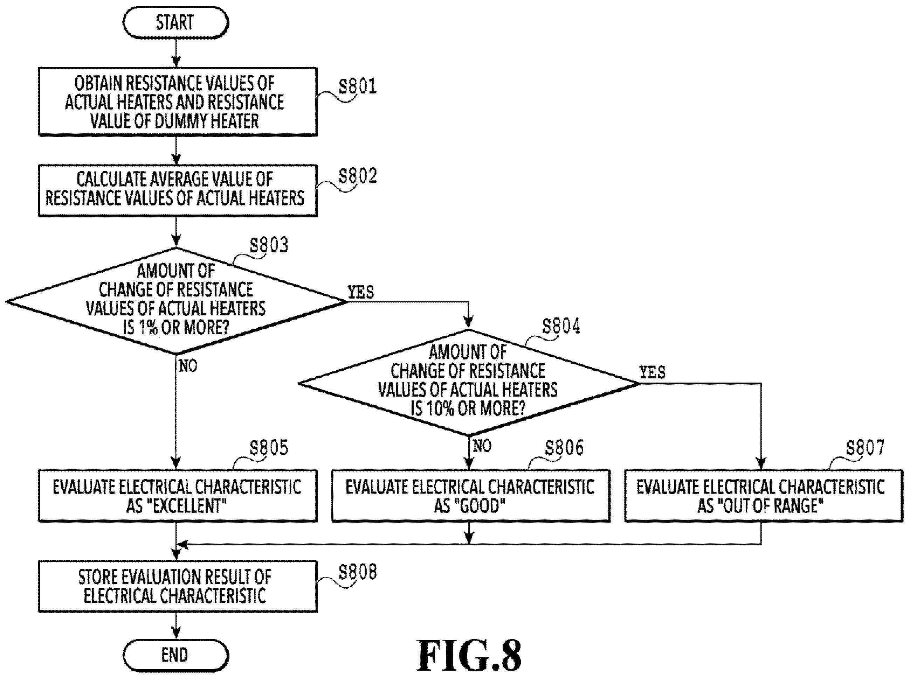

Fig. 8 is a diagram illustrating the subroutine in S703. In the present embodiment, the subroutine in S703 is executed by a control unit of the predetermined inspection apparatus.

In S801, the resistance values of the actual heaters and the resistance value of the dummy heater saved in S702 are obtained from the above-described predetermined memory. In the present embodiment, the resistance value of the dummy heater is treated as an initial resistance value.

In S802, an average value of the resistance values of the actual heaters is calculated.

In S803, whether the resistance values (the average value obtained in S802) of the actual heaters in the head cartridge as a processing target is changed by 1% or more with respect to the initial resistance value is determined. That is, whether an amount of change of the resistance values of the actual heaters is less than 1% is determined. In the determination, it is assumed that the resistance value of the dummy heater is the initial resistance value in the actual heater. Then, whether the resistance values of the actual heaters in the head cartridge as the processing target are changed by 1% or more with respect to the initial resistance value (the resistance value of the dummy heater) is determined. If a ratio of the amount of change of the resistance values of the actual heaters is 1% or more, processing in S804 is performed. On the other hand, if the ratio of the amount of change of the resistance values of the actual heaters is less than 1%, processing in S805 is performed.

Note that, although the extent to which the average value of the resistances in the actual heater is changed with respect to the initial resistance value is determined in the present embodiment, the extent of change of all the resistance values of the actual heaters with respect to the initial resistance value may be determined without calculating the average value of the resistances in the actual heater.

In S804, whether the resistance values of the actual heaters in the head cartridge as the processing target are changed by 10% or more with respect to the initial resistance value is determined. If the ratio of the amount of change of the resistance values of the actual heaters is less than 10%, processing in S806 is performed. On the other hand, if the ratio of the amount of change of the resistance values of the actual heaters is 10% or more, processing in S807 is performed.

In S805, the electrical characteristic of the head cartridge is evaluated as "excellent".

In S806, the electrical characteristic of the head cartridge is evaluated as "good".

In S807, the electrical characteristic of the head cartridge is evaluated as "out of range".

In S808, an evaluation result of the electrical characteristic of the head cartridge is stored. Any one of the evaluations of the electrical characteristic, which are the above-described "excellent," "good," and "out of range," is stored in a memory. An example of the memory that stores the evaluation of the electrical characteristic includes a RAM (not illustrated) included in the inspection apparatus that inspects the head cartridge. In a case where it is possible to make reference in determining the rank of the head cartridge (described later), the evaluation of the electrical characteristic may be written on a memorandum through human intervention.

The above is description of the subroutine in S703. Note that, although it is evaluated that a smaller amount of change in the resistance value of the heater corresponds to a better electrical characteristic in the example in Fig. 8, it may be evaluated that a smaller amount of change in the resistance value of the cavitation resistance layer corresponds to a better electrical characteristic.

Referring back to Fig. 7, and description is continued below.

In S704, the inside of the head cartridge and the ejection port are cleansed.

In S705, outer appearance inspection of the head cartridge is performed. Note that, the head cartridge having a damage that can be identified at a glance on the casing and that is difficult to be recycled may be discarded in S705.

In S706, the outer appearance of the head cartridge is evaluated.

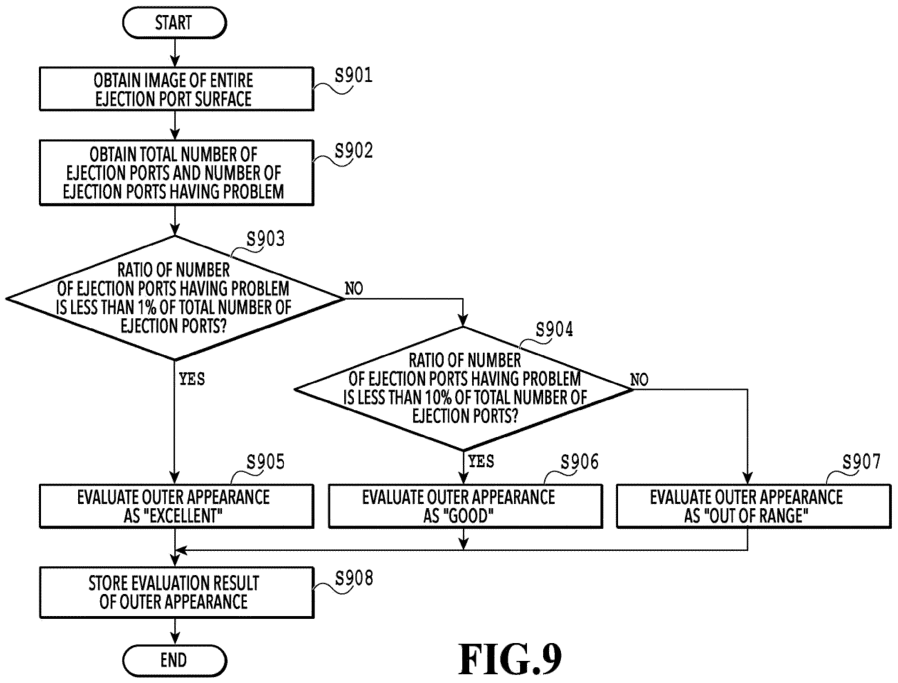

Fig. 9 is a diagram illustrating the subroutine in S706. Only with the result of the electrical inspection on the printing element substrate, it is difficult to determine whether the head cartridge including the printing element substrate is recyclable. Therefore, in S706, evaluation on the outer appearance of the head cartridge including the printing element substrate is performed.

In S901, an image of the entire ejection port surface in the head cartridge is obtained. For example, in S901, the entirety of the ejection port surface is image-captured by an image-capturing apparatus (not illustrated). Then, the captured image is stored in a not-illustrated ROM and the like and obtained by being read out by a not-illustrated CPU.

In S902, the total number of the multiple ejection ports included in the head cartridge and the number of the ejection ports having a problem out of the above ejection ports are obtained. For example, with a publicly-known image analysis using AI being performed on the image of the entire ejection port surface that is obtained by the processing in S901, the total number of the ejection ports is obtained, and the ejection ports having a problem are extracted. An example of the problem that occurs in the ejection port includes clogging with solidified ink, a certain damage, deformation, and so on.

In S903, whether a ratio of the number of the ejection ports having a problem is less than 1% of the total number of the ejection ports is determined. The ratio of the number of the ejection ports having a problem is obtained by the following (Expression 1), for example.

the number of the ejection ports having a problem/the total number of the ejection ports $\times$ 100     (Expression 1)

If the ratio of the number of the ejection ports having a problem is 1% or more of the total number of the ejection ports, processing in S904 is performed. On the other hand, if the ratio of the number of the ejection ports having a problem is less than 1% of the total number of the ejection ports, processing in S905 is performed.

In S904, whether the ratio of the number of the ejection ports having a problem is less than 10% of the total number of the ejection ports is determined.

If the ratio of the number of the ejection ports having a problem is less than 10% of the total number of the ejection ports, processing in S906 is performed. On the other hand, if the ratio of the number of the ejection ports having a problem is 10% or more of the total number of the ejection ports, processing in S907 is performed.

In S905, the outer appearance of the head cartridge is evaluated as "excellent".

In S906, the outer appearance of the head cartridge is evaluated as "good".

In S907, the outer appearance of the head cartridge is evaluated as "out of range".

In S908, an evaluation result of the outer appearance of the head cartridge is stored. Any one of the evaluations of the outer appearance, which are the above-described "excellent," "good," and "out of range," is stored in the memory. An example of the memory includes the RAM (not illustrated) included in the inspection apparatus that inspects the head cartridge. In a case where it is possible to make reference in determining the rank of the head cartridge (described later), the evaluation of the outer appearance may be written on a memorandum through human intervention.

Note that, in S903 and S904 described above, the ratio of the number of the ejection ports having a problem with respect to the total number of the ejection ports is considered. In a case where the total number of the ejection ports is a fixed value, whether the number of the ejection ports having a problem is equal to or greater than a predetermined threshold may be simply determined.

Additionally, in addition to the above, in order to evaluate the water repellency of the ejection port, a step in which a water droplet is dropped on the ejection port surface, an angle formed by the water droplet and the ejection port is measured, and it is determined that a smaller angle corresponds to a higher possibility that there is a problem may be performed.

Moreover, a numerical value described in the present embodiment is merely an example. All the thresholds used in a case of determining whether it is recyclable are appropriately adjustable depending on the characteristic of the head cartridge.

Referring back to Fig. 7, and description is continued below.

In S707, the rank of the head cartridge is determined.

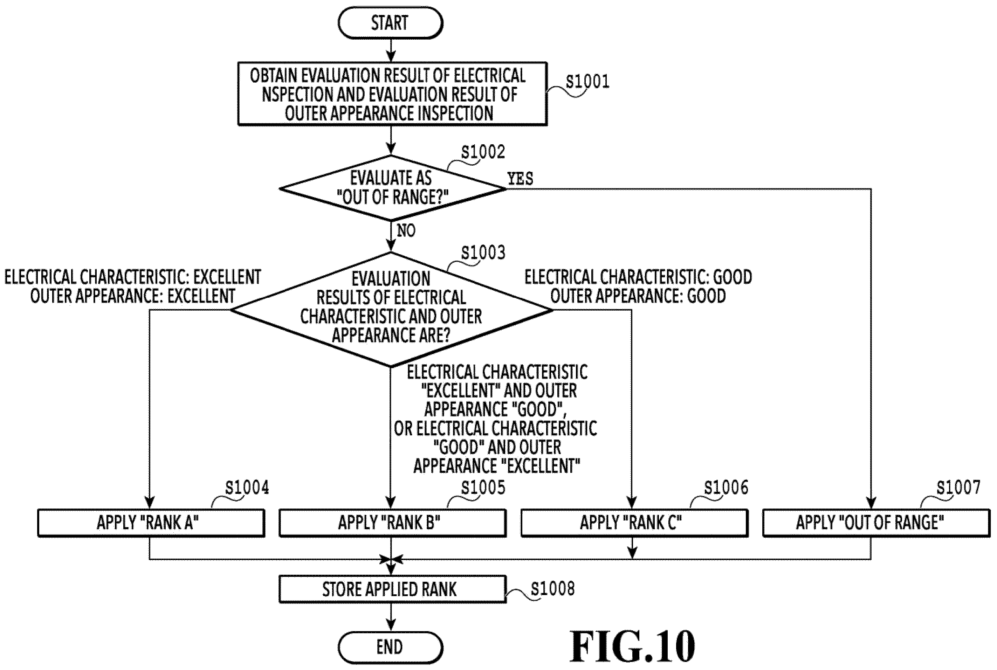

Fig. 10 is a diagram illustrating the subroutine in S707.

In S1001, the evaluation result of the electrical inspection and the evaluation result of the outer appearance inspection are obtained. As described above, the evaluation result of the electrical inspection and the evaluation result of the outer appearance inspection are stored in the not-illustrated memory at a point of time at which the evaluations end. In S1001, the evaluation result of the electrical inspection and the evaluation result of the outer appearance inspection stored in the memory are obtained by being read out by the not-illustrated CPU. As a matter of course, information other than the evaluation result of the electrical inspection and the evaluation result of the outer appearance inspection may be obtained in S1001.

In S1002, with reference to the evaluation result of the electrical inspection and the evaluation result of the outer appearance inspection obtained in S1001, whether the evaluation result of the electrical inspection, the evaluation result of the outer appearance inspection, or both are "out of range" is determined. That is, whether there is the inspection evaluated as "out of range" is determined. If the evaluation result of the electrical characteristic of the head cartridge, the evaluation result of the outer appearance of the head cartridge, or both are "excellent" or "good", processing in S1003 is performed. On the other hand, if at least one of the evaluation results of the electrical characteristic and the outer appearance of the head cartridge is "out of range", processing in S1007 is performed.

In S1003, whether both the evaluation result of the electrical inspection and evaluation result of the outer appearance inspection are "excellent", either one of the evaluation result of the electrical inspection and the evaluation result of the outer appearance inspection is "excellent", or both the evaluation result of the electrical inspection and evaluation result of the outer appearance inspection are "good" is determined. For example, in S1003, with reference to the evaluation result of the electrical inspection and the evaluation result of the outer appearance inspection obtained by the not-illustrated CPU in S1001, the above-described determination is performed. If both the evaluation result of the electrical inspection and evaluation result of the outer appearance inspection are "excellent", processing in S1004 is performed. If either one of the evaluation result of the electrical inspection and the evaluation result of the outer appearance inspection is "excellent" and the other one is "good", processing in S1005 is performed. If both the evaluation result of the electrical inspection and evaluation result of the outer appearance inspection are "good", processing in S1006 is performed.

In S1004, "rank A" is applied as the rank of the head cartridge. The applied rank is stored in the fuse ROM 124 (see Fig. 1).

In S1005, "rank B" is applied as the rank of the head cartridge. The applied rank is stored in the fuse ROM 124 (see Fig. 1) at least.

In S1006, "rank C" is applied as the rank of the head cartridge. The applied rank is stored in the fuse ROM 124 (see Fig. 1) at least.

In S1007, "out of range" is applied as the rank of the head cartridge.

In S1008, the applied rank is stored in the fuse ROM 124 (see Fig. 1). Note that, as long as it is possible to read out the rank in determining whether to discard the head cartridge (described later), the rank may be stored in a memory other than the fuse ROM 124 (for example, the not-illustrated memory included in the inspection apparatus that inspects the head cartridge and the like).

Referring back to Fig. 7, and description is continued below.

In S708, whether to recycle the head cartridge is determined.

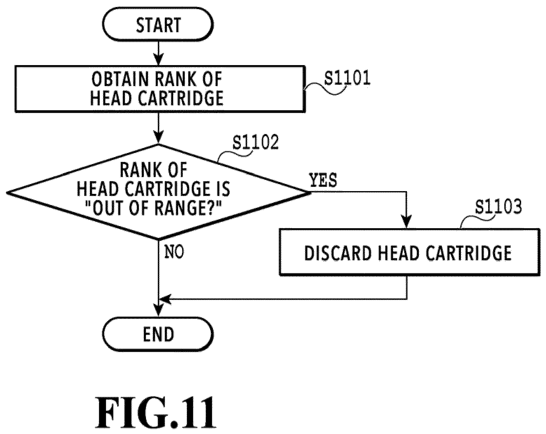

Fig. 11 is a diagram illustrating the subroutine in S708.

In S1101, the rank of the head cartridge stored in the memory (for example, the fuse ROM 124 (see Fig. 1)) is read out and obtained. Note that, in S1101, information other than the rank of the cartridge may be obtained.

In S1102, with reference to the rank of the head cartridge obtained by the processing in S1101, whether the rank of the head cartridge is any one of "rank A" to "rank C" or is "out of range" is determined. That is, whether the rank of the head cartridge is "out of range" is determined. If the rank of the head cartridge is any one of "rank A" to "rank C", the present subroutine ends, and processing in S709 (see Fig. 7) is performed. On the other hand, if the rank of the head cartridge is "out of range," processing in S1103 is performed.

In S1103, the head cartridge is discarded. After S1103 ends, the recycling step of the head cartridge in the present embodiment ends.

Referring back to Fig. 7, and description is continued below.

In S709, the head cartridge is filled with the ink. Note that, in the present embodiment, a filling amount of the ink is changed depending on the rank of the head cartridge.

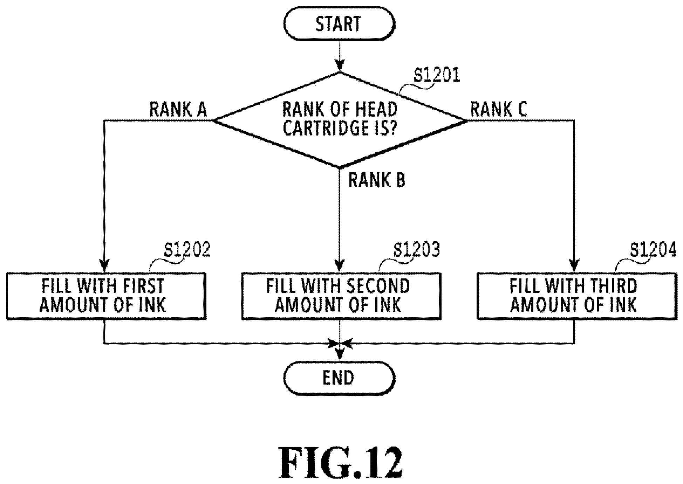

Fig. 12 is a diagram illustrating the subroutine in S709. In the present embodiment, the filling amount of the ink is increased in the order from "rank A", "rank B", and "rank C". This is because it is rational to fill the head cartridge in a better state with more ink.

In S1201, with reference to the rank of the head cartridge stored in the memory (for example, the fuse ROM 124 (see Fig. 1)), whether the rank is "rank A", "rank B", or "rank C" is determined. If the rank of the head cartridge is "rank A", processing in S1202 is performed. If the rank of the head cartridge is "rank B", processing in S1203 is performed. If the rank of the head cartridge is "rank C", processing in S1204 is performed.

In S1202, the head cartridge is filled with a first amount of the ink. For example, the head cartridge is filled with the same amount of the ink as the filling amount for a new (initial state) cartridge. After S1202 ends, the recycling step of the head cartridge in the present embodiment ends.

In S1203, the head cartridge is filled with a second amount of the ink, which is less than the first amount. After S1203 ends, the recycling step of the head cartridge in the present embodiment ends.

In S1204, the head cartridge is filled with a third amount of the ink, which is less than the second amount. After S1204 ends, the recycling step of the head cartridge in the present embodiment ends.

As described above, in the present embodiment, the head cartridge on which the electrical inspection is performed and having a problem in the electrical characteristic is exempted from the recycling step. Accordingly, even in a case of passing the outer appearance inspection, if there is a problem in the electrical characteristic, the head cartridge is exempted from the recycling step.

According to the above-described recycling method, it is possible to suppress determining the head cartridge having no problem in the outer appearance but inside as the recycling target, and it is possible to improve the reliability of the determination. As a result, it is possible to make small a margin included in the threshold for the number of days elapsed from the date on which the cartridge is mounted on the printer, and it is possible to extend a period of continuous use longer than ever before and improve the usability.

In addition, in the recycling method of the present embodiment, the higher the rank of the head cartridge, the greater the filling amount of the ink. According to this method, it is rational because the head cartridge with high possibility of use for a long period of time after recycling is filled with a great amount of the ink.

On the other hand, in the method of the present embodiment, the lower the rank of the head cartridge, the smaller the filling amount of the ink. Thus, even in a case of a state in which the head cartridge after recycling cannot be used because of a worse state than that of the head cartridge of rank A, it is possible to reduce an amount of waste ink.

Therefore, according to the method of the present embodiment, it is possible to determine whether the cartridge is recyclable more accurately than a conventional technology.

[Second Embodiment]

An object of the present embodiment is to provide a method that can determine whether the cartridge is recyclable more accurately than the first embodiment.

In the description below, the same reference numerals are applied and descriptions are omitted for a configuration similar to or corresponding to that in the first embodiment, and different points are mainly described.

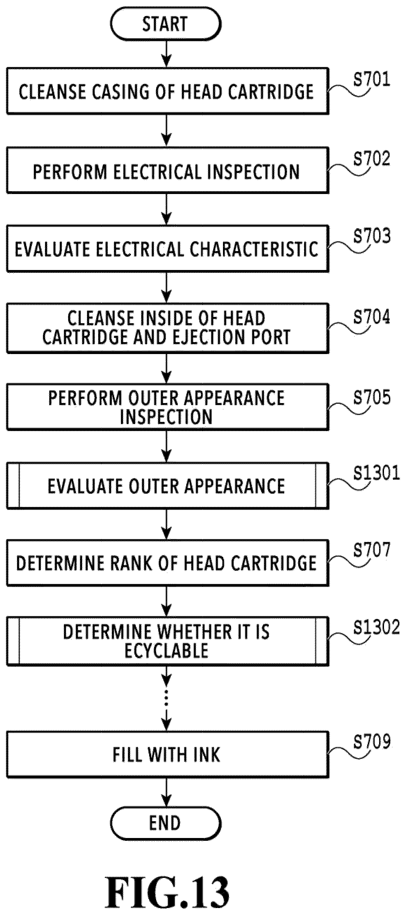

Fig. 13 is a flowchart illustrating the recycling method of the head cartridge applicable to the present embodiment.

As illustrated in Fig. 13, in the present embodiment, S1301 is performed instead of S706 in the first embodiment, and S1302 is performed instead of S708. Note that, another step may be performed before S709 starts after S1302 ends.

In S1301, the outer appearance of the head cartridge in the present embodiment is evaluated.

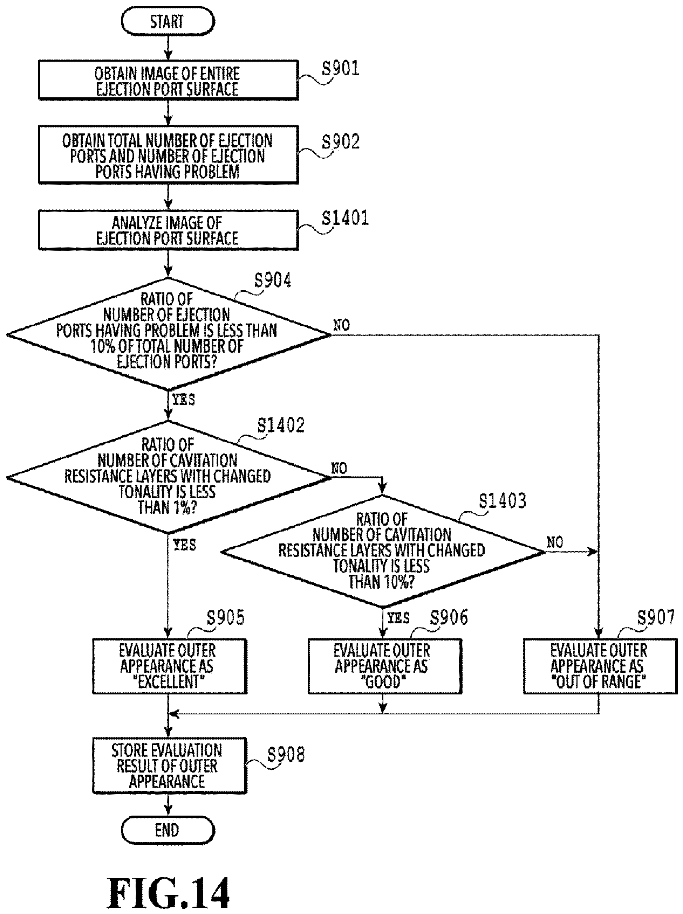

Fig. 14 is a diagram illustrating the subroutine in S1301. Note that, a step indicated by the same reference numeral as that in Fig. 9 has a similar content as that described in Fig. 9; for this reason, description with reference to Fig. 14 is omitted.

In S1401, the publicly-known image analysis is performed on the image of the entire ejection port surface obtained in S901. Then, the cavitation resistance layer 404 that has tonality changed by a specified value or more from the initial state is extracted from the multiple cavitation resistance layers 404 (see Fig. 4).

In a case of viewing the ejection port surface of the present embodiment so as to face in an ejection direction, the cavitation resistance layer 404 is immediately below the ejection port 301 (see Fig. 4). It is possible to guess reduction of the performance of the ejection port 301 by looking at the cavitation resistance layer 404 through the ejection port 301.

For example, it is assumed that the cavitation resistance layer 404 is burnt by heating of the heater 405 and the tonality is darker than the initial state. In this case, it is possible to guess that the performance of the ejection port 301 corresponding to the cavitation resistance layer 404 is lower than the initial state. As described above, the multiple heaters 405 in the present embodiment include the actual heaters actually used for the ejection and the dummy heater that is not used for the ejection. Although the tonality of all the cavitation resistance layers 404 is obtained in S1401, the tonality of the cavitation resistance layer 404 connected to the dummy heater is obtained as the tonality of the initial state.

In S1402, whether a ratio of the number of the cavitation resistance layers having the tonality changed from the initial state by a specified value or more is less than 1% of the total number of the cavitation resistance layers is determined. For example, it is possible to obtain the ratio of the number of the cavitation resistance layers with the changed tonality by the following (Expression 2). Note that, the total number of the cavitation resistance layers are the same as the total number of the ejection ports.

the number of the cavitation resistance layers with the changed tonality/ the total number of the cavitation resistance layers × 100 (Expression 2)

If the ratio of the number of the cavitation resistance layers with the changed tonality is 1% or more of the total number of the cavitation resistance layers, processing in S1403 is performed. On the other hand, if the ratio of the number of the cavitation resistance layers with the changed tonality is less than 1% of the total number of the cavitation resistance layers, the processing in S905 is performed.

In S1403, whether the ratio of the number of the cavitation resistance layers having the tonality that is changed from the initial state by a specified value or more is less than 10% of the total number of the cavitation resistance layers is determined.

If the ratio of the number of the cavitation resistance layers with the changed tonality is less than 10% of the total number of the cavitation resistance layers, the processing in S906 is performed. On the other hand, if the ratio of the number of the cavitation resistance layers with the changed tonality is 10% or more of the total number of the cavitation resistance layers, the processing in S907 is performed.

In the present embodiment, after S905, S906, or S907 ends, the processing in S908 is performed.

Referring back to description of Fig. 13. In S1302, whether the head cartridge of the present embodiment is recyclable is determined.

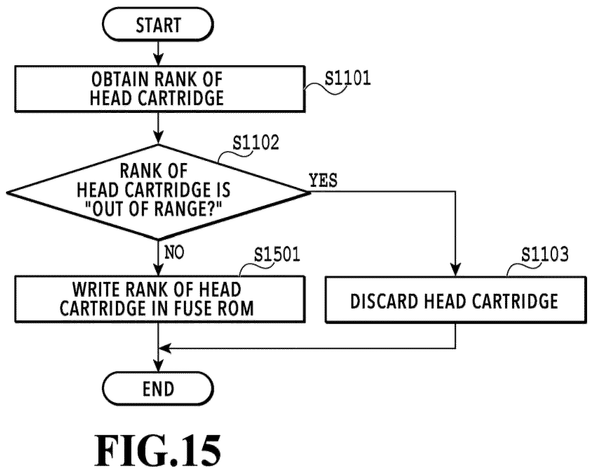

Fig. 15 is a diagram illustrating the subroutine in S1302.

As illustrated in Fig. 15, in the present embodiment, if the rank of the head cartridge is any one of "rank A" to "rank C" after the determination in S1102, processing in S1501 is performed.

In S1501, the rank of the head cartridge is written and stored in the fuse ROM 124 (Fig. 1). Note that, instead of the fuse ROM 124, an EEPROM that can be rewritten many times may be used, or a one time programmable (OTP) memory may be used. It should be noted that, in a case where the OTP memory is used, a memory region dedicated for recycling has to be prepared in expectation of reusing the cartridge.

With the rank of the head cartridge being written in a storage unit (for example, the fuse ROM 124), it is unnecessary to fill the head cartridge with the ink immediately after the determination of the rank of the head cartridge. That is, it is possible to fill the head cartridge with the ink in an arbitrary timing after the determination of the rank of the head cartridge.

As described above, comparing with the first embodiment, in a case where the rank of the head cartridge is determined, an amount of change of the tonality of the cavitation resistance layer is also taken into consideration in the present embodiment. Then, the rank of the head cartridge is stored in the fuse ROM 124.

Therefore, according to the method in the present embodiment, it is possible to determine the state of the head cartridge more accurately. In addition, it is possible to fill the head cartridge with the ink in an arbitrary timing after the determination of the rank of the head cartridge.

[Other Embodiments]

Although the description assuming the head cartridge of a thermal type using the heater is provided in the first and second embodiments, the recycling method of the present disclosure is also applicable to the head cartridge of a piezoelectric type.

The first and second embodiments may be combined with the above-described reference example. For example, a step of determining that it is unrecyclable in a case where an elapsed period of time from the mounting of the head cartridge newly on the liquid ejection apparatus is equal to or more than a predetermined period of time may be included in the flow of the first or second embodiment. On the other hand, a step of determining that it is recyclable in a case where the elapsed period of time from the mounting of the head cartridge newly on the liquid ejection apparatus is less than the predetermined period of time may be included.

Additionally, a step of determining that it is unrecyclable in a case where the number of sheets printed by using the head cartridge is equal to or more than a predetermined number of sheets may be included in the flow of the first or second embodiment. On the other hand, a step of determining that it is recyclable in a case where the number of sheets printed by using the head cartridge is less than the predetermined number of sheets may be included.

Moreover, the flow of the first or second embodiment includes steps of storing the evaluation of the electrical characteristic, the evaluation of the outer appearance, the rank of the head cartridge, and the like in the memory. In the steps, the information such as the evaluation and the rank may be stored by an operation performed through human intervention. Then, whether to recycle the head cartridge may be determined through human intervention with reference to the information.

According to the method of the present disclosure, it is possible to accurately determine whether a cartridge is recyclable.

While the present disclosure has been described with reference to exemplary embodiments, it is to be understood that the present disclosure is not limited to the disclosed exemplary embodiments. The scope of the following claims is to be accorded the broadest interpretation so as to encompass all such modifications and equivalent structures and functions.

Various embodiments have been described in detail above but it will be understood that the present disclosure is not limited to these embodiments and encompasses all modifications, variants, alternatives and equivalents falling within the scope of the appended claims.


**Claims**

1.    A recycling method of a cartridge (120) including

   a tank (121) configured to contain ink,
   a printing element substrate (123) including a plurality of printing elements configured to generate energy to eject the ink according to an electric signal and a plurality of ejection ports (301) formed in positions corresponding to the plurality of printing elements, and
   a wiring substrate in which the electric signal supplied to the printing element substrate (123) is inputted, the recycling method comprising:

      performing electrical evaluation to evaluate an electrical characteristic of the printing element substrate (123) by supplying electric power to the printing element (123) substrate from the wiring substrate;
      performing outer appearance evaluation to evaluate an outer appearance of the cartridge (120) based on the number of the ejection ports (301) having a problem out of the plurality of ejection ports (301); and
      determining whether to recycle the cartridge (120) based on a result of the electrical evaluation and a result of the outer appearance evaluation.

2.    The recycling method according to claim 1, further comprising:

   filling the tank (121) with the ink, wherein
   in the determining, a rank based on how good a state of the cartridge (120) is determined, and
   in the filling, a filling amount of the ink is changed depending on the rank.

3.    The recycling method according to claim 2, wherein
   in the filling, the higher the rank, the greater the filling amount of the ink.

4.    The recycling method according to claim 3, wherein

   in the filling, the cartridge (120) is filled with a first amount of the ink in a case of a first rank indicating that the state of the cartridge (120) is the best, and
   the cartridge (120) is filled with a second amount of the ink less than the first amount in a case where the rank is a second rank lower than the first rank.

5.    The recycling method according to claim 4, wherein

   in the electrical evaluation, a resistance value of a dummy element that is not used for ejection out of the plurality of printing elements is obtained as an initial resistance value,
   a resistance value of an actual element that is used for ejection out of the plurality of printing elements is obtained, and
   in a case where,
   a ratio of the resistance value of the actual element different from the resistance value of the dummy element is less than a first ratio, and
   in the outer appearance evaluation, the number of the ejection ports (301) having a problem out of the plurality of ejection ports (301) is less than a first number,
   in the determining, it is determined as the first rank out of a plurality of ranks indicating how good the state of the cartridge (120) is.

6. The recycling method according to claim 5, wherein

in a case where,
in the electrical evaluation, an amount of difference in the resistance value of the actual element from the resistance value of the dummy element is less than the first ratio, and
in the outer appearance evaluation, the number of the ejection ports (301) having a problem out of the plurality of ejection ports (301) is equal to or greater than the first number and smaller than a second number that is greater than the first number,
in the filling, the cartridge (120) is filled with the second amount of the ink.

7. The recycling method according to claim 6, wherein
in the filling, in a case where the rank is a third rank lower than the second rank, the cartridge (120) is filled with a third amount of the ink less than the second amount.

8. The recycling method according to claim 7, wherein

in a case where,
in the electrical evaluation, the ratio of the resistance value of the actual element different from the resistance value of the dummy element is equal to or greater than the first ratio and less than a second ratio, and
in the outer appearance evaluation, the number of the ejection ports (301) having a problem out of the plurality of ejection ports (301) is equal to or greater than the first number and smaller than the second number,
in the filling, the cartridge (120) is filled with the third amount of the ink.

9. The recycling method according to any one of claims 6 to 8, wherein

in a case where,
in the electrical evaluation, the ratio of the resistance value of the actual element different from the resistance value of the dummy element is equal to or greater than a second ratio,
in the determining, it is determined that the cartridge (120) is unrecyclable.

10. The recycling method according to any one of claims 6 to 9, wherein

in a case where,
in the outer appearance evaluation, the number of the ejection ports (301) having a problem out of the plurality of ejection ports (301) is equal to or greater than the second number,
in the determining, it is determined that the cartridge (120) is unrecyclable.

11. The recycling method according to any one of claims 6 to 10, wherein

in the outer appearance evaluation, change of tonality of a surface covering the printing element is further evaluated, and
in the determining, in a case where an amount of change of the tonality of the surface from initial tonality is equal to or greater than a predetermined amount of change, it is determined that the cartridge (120) is unrecyclable.

12. The recycling method according to claim 11, wherein
the surface covering the printing element is a cavitation resistance layer configured to protect the printing element.

13. The recycling method according to any one of claims 1 to 12, wherein
the printing element is a heater (405).

14. The recycling method according to any one of claims 1 to 13, wherein
in the outer appearance evaluation, an ejection port (301) that is clogged out of the plurality of ejection ports (301) is the ejection port (301) having a problem.

15. The recycling method according to any one of claims 2 to 14, wherein

the cartridge (120) further includes a storage unit configured to store the rank, and
the recycling method further comprises writing the rank into the storage unit.

16. The recycling method according to claim 15, wherein
in the determining, in a case where an elapsed period of time from mounting of the cartridge (120) on a liquid ejection apparatus configured to eject the ink is less than a predetermined period of time, whether to recycle the cartridge (120) is determined based on a result of the electrical evaluation and a result of the outer appearance evaluation.

17. The recycling method according to claim 15 or 16, wherein

the storage unit is configured to be able to store the number of times of printing in which the ink is ejected on a printing medium, and
in the determining, in a case where the number of times of printing is less than a predetermined number of times, whether to recycle the cartridge (120) is determined based on a result of the electrical evaluation and a result of the outer appearance evaluation.

18. A cartridge (120), comprising:

a tank (121) configured to contain ink;
a printing element substrate (123) including a plurality of printing elements configured to generate energy to eject the ink according to an electric signal and a plurality of ejection ports (301) formed in positions corresponding to the plurality of printing elements;
a wiring substrate in which the electric signal supplied to the printing element substrate (123) is inputted; and
a memory configured to store information related to whether it is recyclable based on an evaluation result of an electrical characteristic in the printing element substrate (123) and an evaluation result related to the number of the ejection ports (301) having a problem out of the plurality of ejection ports (301).

19. The cartridge (120) according to claim 18, wherein

the information related to whether it is recyclable includes a plurality of ranks, and
the higher the rank, the greater an amount of the ink contained in the tank (121).

20. The cartridge (120) according to claim 18 or 19, wherein
the memory is a fuse ROM or an EEPROM.

**FIG.1**

EP 4 674 628 A1

FIG.2

**FIG.3**

EP 4 674 628 A1

FIG.4

17

START

CLEANSE CASING OF HEAD CARTRIDGE — S501

DETERMINE WHETHER HEAD CARTRIDGE IS RECYCLABLE — S502

CLEANSE INSIDE OF HEAD CARTRIDGE — S503

FILL HEAD CARTRIDGE WITH LIQUID — S504

END

# FIG.5

START

READ EEPROM — S601

NUMBER OF DAYS ELAPSED IS WITHIN PREDETERMINED VALUE? — S602

NO →

YES ↓

NUMBER OF SHEETS PRINTED IS WITHIN PREDETERMINED VALUE? — S603

NO →

YES ↓

CASING HAS NO PROBLEM? — S604

NO →

YES

DETERMINE AS RECYCLABLE — S605

DETERMINE AS UNRECYCLABLE — S606

END

# FIG.6

19

```
            ┌─────────────┐
            │    START    │
            └─────────────┘
                   │
                   ▼
    ┌──────────────────────────────────┐
    │  CLEANSE CASING OF HEAD CARTRIDGE │──S701
    └──────────────────────────────────┘
                   │
                   ▼
    ┌──────────────────────────────────┐
    │   PERFORM ELECTRICAL INSPECTION   │──S702
    └──────────────────────────────────┘
                   │
                   ▼
    ┌──────────────────────────────────┐
    │  EVALUATE ELECTRICAL CHARACTERISTIC│──S703
    └──────────────────────────────────┘
                   │
                   ▼
    ┌──────────────────────────────────┐
    │      CLEANSE INSIDE OF HEAD       │──S704
    │   CARTRIDGE AND EJECTION PORT     │
    └──────────────────────────────────┘
                   │
                   ▼
    ┌──────────────────────────────────┐
    │ PERFORM OUTER APPEARANCE INSPECTION│──S705
    └──────────────────────────────────┘
                   │
                   ▼
    ┌──────────────────────────────────┐
    │     EVALUATE OUTER APPEARANCE     │──S706
    └──────────────────────────────────┘
                   │
                   ▼
    ┌──────────────────────────────────┐
    │  DETERMINE RANK OF HEAD CARTRIDGE │──S707
    └──────────────────────────────────┘
                   │
                   ▼
    ┌──────────────────────────────────┐
    │  DETERMINE WHETHER IT IS RECYCLABLE│──S708
    └──────────────────────────────────┘
                   │
                   ▼
    ┌──────────────────────────────────┐
    │           FILL WITH INK           │──S709
    └──────────────────────────────────┘
                   │
                   ▼
            ┌─────────────┐
            │     END     │
            └─────────────┘
```

# FIG.7

START

OBTAIN RESISTANCE VALUES OF ACTUAL HEATERS AND RESISTANCE VALUE OF DUMMY HEATER ⟩ S801

CALCULATE AVERAGE VALUE OF RESISTANCE VALUES OF ACTUAL HEATERS ⟩ S802

S803
AMOUNT OF CHANGE OF RESISTANCE VALUES OF ACTUAL HEATERS IS 1% OR MORE? — YES

NO

S804
AMOUNT OF CHANGE OF RESISTANCE VALUES OF ACTUAL HEATERS IS 10% OR MORE? — YES

NO

S805
EVALUATE ELECTRICAL CHARACTERISTIC AS "EXCELLENT"

S806
EVALUATE ELECTRICAL CHARACTERISTIC AS "GOOD"

S807
EVALUATE ELECTRICAL CHARACTERISTIC AS "OUT OF RANGE"

STORE EVALUATION RESULT OF ELECTRICAL CHARACTERISTIC ⟩ S808

END

**FIG.8**

FIG.9

START

S901 — OBTAIN IMAGE OF ENTIRE EJECTION PORT SURFACE

S902 — OBTAIN TOTAL NUMBER OF EJECTION PORTS AND NUMBER OF EJECTION PORTS HAVING PROBLEM

S903 — RATIO OF NUMBER OF EJECTION PORTS HAVING PROBLEM IS LESS THAN 1% OF TOTAL NUMBER OF EJECTION PORTS?

NO → S904 — RATIO OF NUMBER OF EJECTION PORTS HAVING PROBLEM IS LESS THAN 10% OF TOTAL NUMBER OF EJECTION PORTS?

YES → S905 — EVALUATE OUTER APPEARANCE AS "EXCELLENT"

S904 YES → S906 — EVALUATE OUTER APPEARANCE AS "GOOD"

S904 NO → S907 — EVALUATE OUTER APPEARANCE AS "OUT OF RANGE"

S908 — STORE EVALUATION RESULT OF OUTER APPEARANCE

END

FIG.10

EP 4 674 628 A1

START

OBTAIN RANK OF
HEAD CARTRIDGE — S1101

RANK OF
HEAD CARTRIDGE IS
"OUT OF RANGE?" — S1102

YES

DISCARD HEAD CARTRIDGE — S1103

NO

END

# FIG.11

START

S1201

RANK A — RANK OF HEAD CARTRIDGE IS? — RANK C

RANK B

S1202
FILL WITH FIRST AMOUNT OF INK

S1203
FILL WITH SECOND AMOUNT OF INK

S1204
FILL WITH THIRD AMOUNT OF INK

END

# FIG.12

START

CLEANSE CASING OF HEAD CARTRIDGE    S701

PERFORM ELECTRICAL INSPECTION    S702

EVALUATE ELECTRICAL CHARACTERISTIC    S703

CLEANSE INSIDE OF HEAD
CARTRIDGE AND EJECTION PORT    S704

PERFORM OUTER APPEARANCE
INSPECTION    S705

EVALUATE OUTER APPEARANCE    S1301

DETERMINE RANK OF HEAD CARTRIDGE    S707

DETERMINE WHETHER IT IS
ECYCLABLE    S1302

FILL WITH INK    S709

END

# FIG.13

START

OBTAIN IMAGE OF ENTIRE
EJECTION PORT SURFACE — S901

OBTAIN TOTAL NUMBER OF EJECTION
PORTS AND NUMBER OF EJECTION
PORTS HAVING PROBLEM — S902

ANALYZE IMAGE OF
EJECTION PORT SURFACE — S1401

RATIO OF
NUMBER OF EJECTION
PORTS HAVING PROBLEM IS LESS THAN
10% OF TOTAL NUMBER OF
EJECTION PORTS? — S904 — NO

YES

RATIO OF
NUMBER OF CAVITATION
RESISTANCE LAYERS WITH CHANGED
TONALITY IS LESS
THAN 1%? — S1402 — NO

RATIO OF
NUMBER OF CAVITATION
RESISTANCE LAYERS WITH CHANGED
TONALITY IS LESS
THAN 10%? — S1403 — NO

YES

YES

EVALUATE OUTER
APPEARANCE AS
"EXCELLENT" — S905

EVALUATE OUTER
APPEARANCE AS
"GOOD" — S906

EVALUATE OUTER
APPEARANCE AS
"OUT OF RANGE" — S907

STORE EVALUATION
RESULT OF OUTER
APPEARANCE — S908

END

# FIG.14

START

OBTAIN RANK OF
HEAD CARTRIDGE — S1101

RANK OF
HEAD CARTRIDGE IS
"OUT OF RANGE?" — S1102

YES

NO

WRITE RANK OF HEAD
CARTRIDGE IN FUSE ROM — S1501

DISCARD HEAD CARTRIDGE — S1103

END

# FIG.15

Europäisches
Patentamt
European
Patent Office
Office européen
des brevets

# EUROPEAN SEARCH REPORT

**Application Number**

EP 25 18 7249

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/097770 A1 (LOW TONG NAM SAMUEL [SG] ET AL) 24 April 2008 (2008-04-24) * figures 1-4 * * paragraph [0016] * * paragraph [0020] - paragraph [0026] * ----- | 1-20 | INV. B41J2/175 |
| A | KR 2004 0042567 A (PARK HYUNG WOO) 20 May 2004 (2004-05-20) * figures 1-4 * * paragraph [0048] * * paragraph [0063] - paragraph [0065] * ----- | 1-20 | |
| A | US 2007/109340 A1 (NICODEM HARRY E [US]) 17 May 2007 (2007-05-17) * figures 1-5 * * paragraph [0028] * * paragraph [0040] * ----- | 1-20 | |
| A | US 2008/079790 A1 (KACHI YASUHIKO [JP]) 3 April 2008 (2008-04-03) * figures 1-2, 10 * * paragraph [0085] * * paragraph [0112] * ----- | 1-20 | **TECHNICAL FIELDS SEARCHED (IPC)** B41J |

The present search report has been drawn up for all claims

| Place of search | Date of completion of the search | Examiner |
|---|---|---|
| The Hague | 21 November 2025 | João, César |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 25 18 7249

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2025

| Patent document cited in search report | Publication date | Patent family member(s) | Publication date |
|---|---|---|---|
| US 2008097770 A1 | 24-04-2008 | US 2008097770 A1<br>US 2010241505 A1 | 24-04-2008<br>23-09-2010 |
| KR 20040042567 A | 20-05-2004 | NONE | |
| US 2007109340 A1 | 17-05-2007 | NONE | |
| US 2008079790 A1 | 03-04-2008 | JP 4806616 B2<br>JP 2008087282 A<br>US 2008079790 A1 | 02-11-2011<br>17-04-2008<br>03-04-2008 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002264435 A